# EUROPEAN PATENT SPECIFICATION

(11) **EP 3 375 269 B1**
(45) Date of publication and mention of the grant of the patent: **29.12.2021**
(21) Application number: 16801158.3
(22) Date of filing: 10.11.2016
(51) Int. Cl.: H05K 9/00, G06K 19/077, H01Q 1/22, H01Q 1/38

(54) **PROCESS FOR PROVIDING DEVICES OF THE TYPE OF AN ANTENNA, A HEATER, AN ELECTROMAGNETIC SCREEN, AN ELECTRICAL INTERCONNECTION AND THE LIKE**
VERFAHREN ZUR BEREITSTELLUNG VON VORRICHTUNGEN VOM TYP EINER ANTENNE, EINES HEIZGERÄTS, EINES ELEKTROMAGNETISCHEN SCHIRMS, EINER, ELEKTRISCHE VERBINDUNG UND DERGLEICHEN
PROCÉDÉ POUR FOURNIR DES DISPOSITIFS DU TYPE ANTENNE, DISPOSITIF DE CHAUFFAGE, ÉCRAN ÉLECTROMAGNÉTIQUE, INTERCONNEXION ÉLECTRIQUE ET ANALOGUES

(30) Priority: 11.11.2015 IT UB20155495
(43) Date of publication of application: 19.09.2018
(73) Proprietor: Consiglio Nazionale delle Ricerche, 00185 Roma (IT)
(72) Inventor: TREOSSI, Emanuele, 47013 Dovadola (IT); SCIDA', Alessandra, 47121 Forlì (IT); PALERMO, Vincenzo, 40131 Bologna (IT)
(74) Representative: Modiano, Micaela Nadia
(86) International application number: PCT/EP2016/077337
(87) International publication number: WO 2017/081195

(56) References cited:
- EP-A1- 2 772 873
- CN-A- 104 134 870
- US-A1- 2012 013 989
- US-A1- 2013 004 658
- US-A1- 2015 309 391
- US-B1- 8 664 642

## Description

The present invention relates to a process for providing devices of the type of an antenna, a heater, an electromagnetic screen, an electrical interconnection and the like.

A new class of two-dimensional materials has recently been discovered. Graphene, the first material in this class to be discovered, is a two-dimensional crystal composed of only carbon atoms that are arranged in a honeycomb structure to form a single atomic layer. Graphene has a mechanical strength that exceeds that of steel, it conducts heat better than copper, it is transparent and flexible and it has better electrical properties than those of silicon, which is commonly used in semiconductors and in electronic components.

Such material can be indicated for providing conducting paths of circuits, antennae and the like.

RFID identification systems are used in many fields, for example in the tracking and in the management of goods or storage systems, in the identification of persons or of animals, in toll payment systems, in credit cards, in passports etc.

Recently there has been strong growth in the RFID-NFC (Near Field Communication) devices which is a short range wireless technology. It is reasonable to expect that in the coming years the field of applications in object identification will further increase. For example, flexible RFID tags may represent a turning point in the sector of flexible electronics, but also in current electronics; in fact flexible RFID tags are in great demand for identifying curved objects.

In an RFID system, identification of the objects is provided by a label (tag) which consists of an antenna and an integrated circuit. The electronic product code (EPC) that identifies the object is stored in the memory of the integrated circuit which is read by an RFID reader. In NFC applications, the tags work mainly by virtue of an inductive coupling, and the transfer of the data between the tag and the reader usually occurs by modulating the reflected radiation of the antenna by varying impedance.

In the production of RFID tags, chemical etching is usually employed to create the conducting circuits of the antenna. Chemical etching is a process that comprises many steps and it requires numerous pollutant chemical agents. Furthermore the sublayer is subject to chemical stresses that therefore reduce the variety of usable sublayers. These aspects make it necessary to find solutions for providing RFID antennae that are more ecological and more adaptable.

Ink-jet printing technology, which prints conducting inks with a special printer, is very rapidly becoming established thanks to the low manufacturing cost and to the possibility to modify the thickness of the conducting layer by printing multiple layers. In any case, the development of printed RFID tags is not so immediate because most cheap sublayers that can be printed degrade easily; for example they deform when subjected to mechanical stresses or to high temperatures, as is required in the typical thermal treatments used for conducting inks.

Another problem of current radio frequency identification systems is the corrosion of the metals that are generally used to provide the RFID antenna. The metallic nanoparticles present in the conducting inks that are used for the ink-jet printing of RFID antennae have a very high surface area and therefore they can absorb a great deal of humidity, causing the antenna to oxidize and degrade more rapidly than macroscopic metals. In many applications, RFID devices have to withstand physical or chemical stresses and therefore they have to be corrosion-resistant (autonomously or by virtue of specific forms of protection).

One possible solution to this problem is to use carbon-based materials, which are not subject to corrosion and are thermally very stable. At the same time, however, flexible antennae require flexible films with surface electrical resistance lower than 1-5 ohm/sq (i.e. ohms on a square surface, for a given thickness), in order to obtain acceptable performance levels.

Until now it has not been possible to produce efficient flexible antennae made with graphene derivatives, because with the approaches currently used the films obtained have low electrical conductivity. A critical factor of these approaches is that the contact resistance between adjacent sheets of graphene can be very high if the sheets are not in good contact with each other, thus reducing the total conductivity in the film (even though a single graphene unit conducts current very well).

A special "dipole antenna" (described in the scientific publication by Huang X et al., Applied Physics Letters 2015, Vol. 106, pp. 203105) has been created using a conductive graphene ink, printed on paper by way of an ink-jet printing process and subsequently compressed with rollers.

In particular, through this specific ink-jet printing process with subsequent compression of the deposited layers of ink (which comprises graphene), it is possible to obtain a surface resistance (or superficial resistance) equal to about 3 ohm/sq for a film with a thickness of approximately 7.7 micrometers.

US8664642 discloses graphite-based device comprising a substrate with a plurality of zones and one or more graphene stacks. Each graphene stack is formed by a plurality of graphene layers that are formed on the substrate.

US2012/013989 discloses a meta material comprises a conductive nano pattern on a substrate. The nano pattern has conductive layers that comprise of graphene and that are formed on the substrate.

Obviously the end qualitative level (and therefore the electrical properties of the conducting path provided with this known method) depends on how the graphene-based ink was deposited, on the number of layers and on the quality of the compression exerted on the layers of ink: the factors that influence the provision of a conducting path with good performance levels are many and conflicting.

The merit factor Q of an antenna, an essential parameter for obtaining an efficient antenna, strongly influences the range of action of the RFID tag and is inversely proportional to the resistance of the antenna proper.

Furthermore it must be noted that antennae obtained with ink-jet printing processes (and in particular with ink that comprises graphene, wherein the layers of print are subjected to compression for their compaction) can exhibit, if there are many layers, poor mechanical performance (brittleness, low flexibility etc.) and therefore they are not suitable for positively fulfilling all the various types of application.

An object of the invention is to provide a process for providing devices of the type of an antenna, a heater, an electromagnetic screen, an electrical interconnection and the like which makes it possible to obtain devices simply and ecologically.

Another object of the invention is to provide a process for providing devices of the type of an antenna, a heater, an electromagnetic screen, an electrical interconnection and the like which makes it possible to obtain devices with good mechanical properties, in particular devices that are elastically flexible.

Another object of the invention is to provide a process for providing devices of the type of an antenna, a heater, an electromagnetic screen, an electrical interconnection and the like which has low implementation costs.

Another object of the invention is to provide a process for providing devices of the type of an antenna, a heater, an electromagnetic screen, an electrical interconnection and the like which are low cost, easily and practically implemented and safe in use.

This aim and these and other objects which will become better apparent hereinafter are achieved by a -process for providing devices such as an antenna, a heater, an electromagnetic screen, an electrical interconnection and the like, which consists of:
- selecting at least one sheet essentially constituted by a free-standing preassembled sheet of graphene derivatives;
- selecting at least one supporting layer of material chosen from among polymeric, composite, ceramic, paper, natural substances and combinations and/or derivatives thereof;
- coupling at least one portion of said at least one sheet and at least one portion of said at least one supporting layer;
- shaping from said at least one sheet at least one flexible ribbon-like conducting path in any step of the process, choosing from between prior to the coupling of said at least one sheet to said at least one supporting layer, thus coupling said conducting path on said supporting layer, and after the coupling of said at least one sheet to said at least one supporting layer, thus obtaining a conducting path that is integral with a respective supporting layer that is complementarily shaped.

Further characteristics and advantages of the invention will become better apparent from the description of preferred, but not exclusive, embodiments of the process for providing devices of the type of an antenna, a heater, an electromagnetic screen, an electrical interconnection and the like according to the invention, which are illustrated for the purposes of example in the accompanying drawings wherein:
Figure 1a is a schematic view of a portion of a device according to the invention in a flat position;
Figure 1b is a schematic view of a portion of the device of Figure 1a subjected to bending;
Figure 2 is a schematic view of a process, according to the invention, for providing devices of the type of an antenna, a heater, an electromagnetic screen, an electrical interconnection and the like;
Figure 3 is a front elevation view of a first type of antenna provided with a process according to the invention;
Figure 4 is a perspective view of a second type of antenna provided with a process according
   to the invention in a flexed configuration;
Figure 5 is a front elevation view of a third type of antenna provided with a process according
   to the invention;
Figure 6 is a front elevation view of a fourth type of antenna provided with a process according to the invention;
Figure 7 is a front elevation view of a type of heater provided with a process according to the
   invention;
Figure 8 is a front elevation view of a blank provided as an illustrative example not part of the invention;

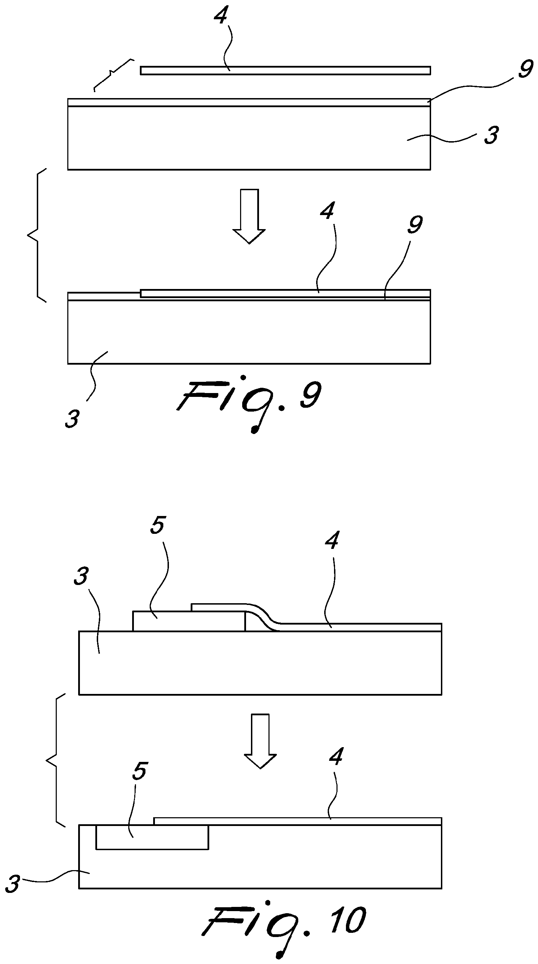

Figure 9 is a side view of two possible steps for coupling the layers in the process according to the invention and adopted in the devices according to the invention;
Figure 10 is a side view of two further possible steps for coupling the layers in the process according to the invention and adopted in the devices according to the invention;
Figure 11 is a side view of a third criterion of coupling the layers in the process according to the invention and adopted in the devices according to the invention;
Figure 12 is a side view of a fourth criterion of coupling the layers in the process according to the invention and adopted in the devices according to the invention;
Figure 13 is a side view of a fifth criterion of coupling the layers in the process according to the invention and adopted in the devices according to the invention.

With reference to the figures, the reference numeral 1 generally designates a device of the type of an antenna, a heater, an electromagnetic screen, an electrical interconnection and the like, and the reference numeral 2 generally designates a process for providing devices 1 of the type of an antenna, a heater, an electromagnetic screen, an electrical interconnection and the like.

The device 1 provided with a process according to the invention comprises at least one laminar supporting layer 3 for at least one flexible ribbon-like conducting path 4 essentially constituted by preassembled graphene derivatives.

It should be noted that the at least one supporting layer 3 is made of a material chosen from among polymeric, composite, ceramic, paper, natural substances and combinations and/or derivatives thereof.

The term "preassembled graphene derivatives" means in particular free-standing preassembled sheets of graphene derivatives: some of these materials are already commercially produced on a large scale and can be made with nanoplatelets of graphene (G-NP) or other preassembled graphene derivatives in sheets or rolls.

Among these, for the purposes of non-limiting example, are the material known as ANG Graphene Foil (produced by Angstron Materials), the XG leaf material (produced by XG Science) and the G2Nan Sheet material (produced by Nanesa). However, the possibility is not ruled out of using different laminar compounds predominantly of preassembled graphene derivatives and/or different materials having similar characteristics or the like.

According to a particular embodiment of particular applicative interest, the at least one flexible ribbon-like conducting path 4 comprises, at its ends, respective connecting elements 5 which are constituted by plates of conducting material preferably chosen from among metals and polymers with good electrical conductivity.

The connecting elements 5 can be made with metallic sheets or plates, conducting polymers, evaporated metals, conducting pastes, other conducting materials that are applied under pressure, etc., or a combination thereof. These can be applied to the ends of the conducting path 4 under or over the surface of the graphene material that constitutes it. It can be done similarly for other applications that make use of conducting circuits or electrical interconnections provided with sheets of graphene derivatives.

With particular reference to an embodiment of undoubted practical and applicative interest, the at least one flexible ribbon-like conducting path 4 comprises units of a material chosen from among graphene, graphene derivatives, graphite, graphite derivatives and other essentially two-dimensional materials (optionally also supramolecularly chemically functionalized, doped or mixed with additives like polymers or metals).

Such units can be predominantly constituted by nanoplatelets, nanosheets, nanofilaments, nanoparticles and the like.

More generally different types of preassembled sheets of graphene derivatives can be used for providing the conducting paths 4. In particular it is possible to use:
- graphene and graphene derivatives in the form of graphene nanoplatelets, graphene nanosheets, graphene nanoribbons, graphene oxide, exfoliated graphene, reduced graphene oxide, multilayer graphene etc.;
- graphite and graphite derivatives in the form of expanded graphite, graphite microplatelets etc.;
- graphene derivatives, graphite derivatives, or other substantially two-dimensional materials, with chemical or supramolecular functionalization;
- graphene derivatives or graphite derivatives with additives used to increase the electrical conductivity or to improve the adhesion to sublayers, such as for example silver nanothreads, copper nanoparticles, polymers etc.

In the invention, the possibility also exists of doping by way of chemical and physical treatments (treatments with doping molecules, e.g. HN03, AuC13, HCl, treatments with plasma, treatments with ozone etc.) the conducting paths 4 in order to improve the electrical, mechanical and chemical properties of the devices 1 that comprise them.

The preassembled graphene derivatives from which the conducting paths 4 are obtained can be provided with different properties and sizes (electrical conductivity, thermal conductivity, thicknesses etc.).

Finally it should be specified that the device 1 according to the invention, in a possible application thereof which is particularly efficient and easy and safe in industrial application, can preferably comprise at least one covering and protection layer 6, arranged above the flexible ribbon-like conducting path 4 and in possible at least partial contact with the supporting layer 3.

The at least one protective layer 6 will positively be made of a material chosen from among polymeric, composite, ceramic, paper, natural substances and combinations and/or derivatives thereof.

The present invention relates to a process for providing devices 1 of the type of an antenna, a heater, an electromagnetic screen, an electrical interconnection and the like which involves a series of steps.

Firstly it is necessary to select at least one sheet 7 which is essentially constituted by preassembled graphene derivatives.

The sheet 7 must therefore be substantially constituted by:
- graphene and graphene derivatives in the form of graphene nanoplatelets, graphene nanosheets, graphene nanoribbons, graphene oxide, exfoliated graphene, reduced graphene oxide, multilayer graphene etc.;
- graphite and graphite derivatives in the form of expanded graphite, graphite microplatelets etc.;
- graphene derivatives, graphite derivatives, or other substantially two-dimensional materials (in which the thickness is often substantially monoatomic), with chemical or supramolecular functionalization;
- graphene derivatives or graphite derivatives with additives used to increase the electrical conductivity or to improve the adhesion to sublayers, such as for example silver nanothreads, copper nanoparticles, polymers etc.

The possibility is not ruled out that the sheet 7 has undergone chemical or physical doping treatments (treatments with doping molecules, e.g. HN03, AuC13, HCl, treatments with plasma, treatments with ozone etc.).

The process according to the invention further involves selecting at least one supporting layer 3 of a material chosen from among polymeric, composite, ceramic, paper, natural substances and combinations and/or derivatives thereof.

For example, it will be possible to use layers 3 of polyethylene terephthalate (PET), thus obtaining high flexibility and excellent adhesion, as well as excellent stability of the electrical and mechanical characteristics over time (even if subjected to mechanical stresses); it is also possible to adopt layers 3 of different composition, such as polyethylene (PE), poly(4,4'-oxydiphenylene-pyromellitimide) (known by the commercial name Kapton^{®}), polytetrafluoroethylene (PTFE), polyvinyl chloride (PVC) and other polymers, or of different thickness.

The process according to the invention is carried out with the coupling of the at least one sheet 7 (which can be folded, rolled to make a spool, constituted by a plurality of separate elements which are stacked and/or piled) and of the at least one portion of the at least one supporting layer 3: this step gives high mechanical properties to the sheet 7 (or to a portion thereof), which acquires the mechanical strength of the supporting layer 3 to which it is coupled.

It is further necessary to cut (more correctly, shape) at least one flexible ribbon-like conducting path 4 from the at least sheet 7 in any step of the process.

In particular it will be possible to choose the moment when to cut/shape the conducting path 4 from the sheet 7 from between:
- prior to the coupling of the at least one sheet 7 to the at least one supporting layer 3, thus coupling the conducting path 4 cut from the sheet to the supporting layer 3 thus obtaining a device 1 having an outer shape wider than the conducting path 4 (outer shape defined by the dimensions of the supporting layer 3);
- after the coupling of the at least one sheet 7 to the at least one supporting layer 3, thus obtaining a device 1 having a shape corresponding exactly to that of the respective conducting path 4 which is integral with a respective supporting layer 3 that has an identical shape structure.

It should be noted that, with reference to the process according to the invention, optionally at least one additional covering and protection layer 6 can be arranged above the flexible ribbon-like conducting path 4 and in possible at least partial contact with the supporting layer 3.

The protective layer 6 preferably will be made of a material chosen from among polymeric, composite, ceramic, paper, natural substances and combinations and/or derivatives thereof.

According to the invention, the step of coupling the at least one sheet 7 with at least one portion of the at least one supporting layer 3 is obtained by way of a method that can be preferably (and not exclusively) chosen from among hot rolling, adhesive bonding, cross-linking, interposition of coupling sheets (for example a layer of adhesive material 9) and the like.

It is moreover useful to note that the step of cutting or modeling of the at least one flexible ribbon-like conducting path 4 from the at least one sheet 7 (independently of whether this is stored in folded or rolled form etc.) can positively be performed by way of a die cutter, a blade controlled by respective actuators, a cutting plotter and the like (although these being non-limiting examples). The possibility is not ruled out of using laser apparatuses or using electrochemical methods for the shaping.

Moreover, in the step of shaping the sheet 7, in some aspects of the invention, fixing sublayers can be used in order to keep the sheet still during the modeling. By way of non-exclusive example, the fixing sublayers can be constituted by polydimethylsiloxane (PDMS), or polyvinyl chloride (PVC), or a thermal release tape or the like.

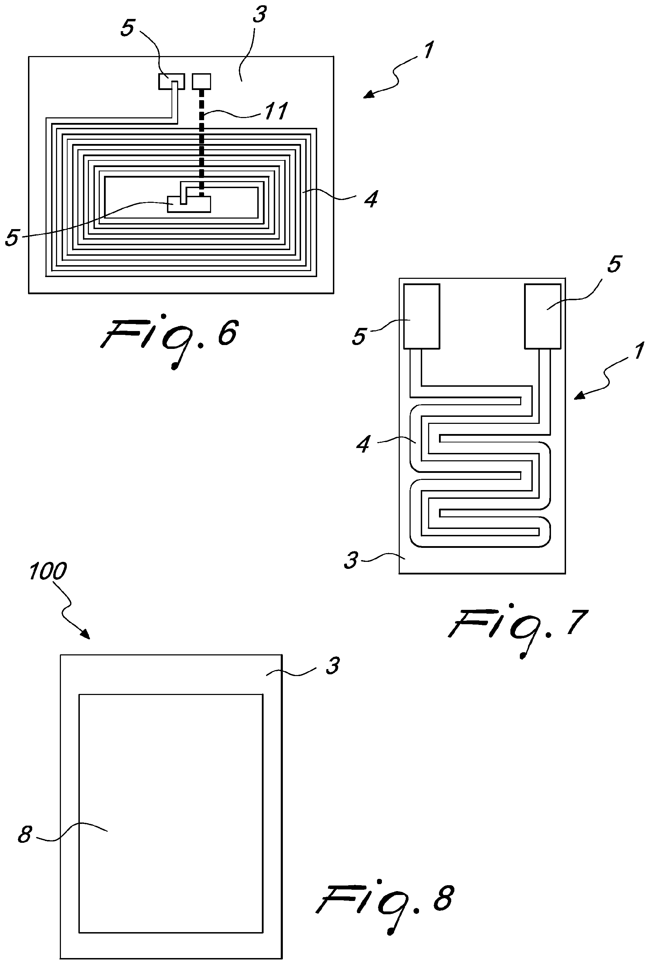

The present disclosure also relates to a substantially laminar blank 100 (shown for the purposes of example, not part of the invention, in Figure 8) for providing devices 1 of the type of an antenna, a heater, an electromagnetic screen, an electrical interconnection and the like which comprises at least one laminar supporting layer 3 made of a material chosen from among polymeric, composite, ceramic, paper, natural substances and combinations and/or derivatives thereof and at least one conducting layer 8 essentially constituted by preassembled graphene derivatives. The conducting layer 8 and the laminar supporting layer 3 are coupled to each other.

The coupling of the conducting layer 8 to the supporting layer 3 confers good mechanical properties on this conducting material which is usually rather brittle: the conducting layer 8 acquires the mechanical strength of the supporting layer 3 to which it is coupled.

The blank 100 can further comprise at least one additional covering and protection layer 6, arranged above the flexible ribbon-like conducting path 4 and in at least partial contact with such supporting layer 3.

The protective layer 6 can be made of a material chosen from among polymeric, composite, ceramic, paper, natural substances and combinations and/or derivatives thereof.

The devices 1 provided by a process according to the invention are not limited to flexible applications; in fact they can be coupled to non-flexible layers 3 as well. The high mechanical strength of the preassembled graphene sheets 7, together with their low thermal expansion coefficient and their high flexibility, make it possible to associate the sheet 7 with a great variety of different layers 3. Considering that the sheet 7, constituted by preassembled graphene derivatives, is composed only of carbon, in any case it is certain that it will have a good affinity and capacity for adhesion to a great variety of different layers 3.

It can also be envisaged free-standing (i.e. not attached to a sublayer) antennae or electrical interconnections obtained with this material and with these cutting techniques.

The application of the invention is not limited only to antennae for NFC (Near Field Communication) but in general to other types of antennae, e.g. dipole or patch etc..

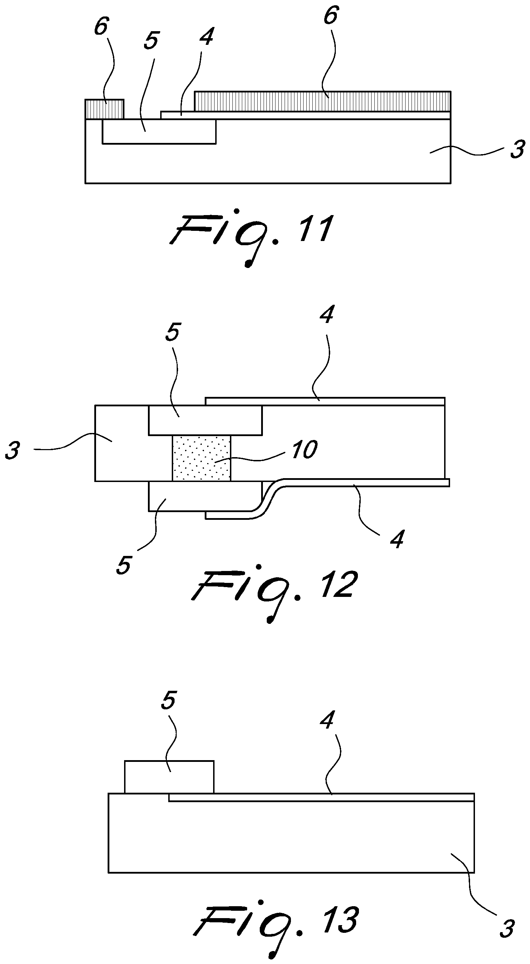

The protective layer 6 that can be applied on a part of the antenna can allow the passage of an electrical connection 11 from the inner end of the antenna to the outer end. If an electrically insulating sublayer (e.g. PET) is used to provide the antenna, it is possible to use this as a dielectric instead of the protective layer by passing the contacts under it by way of a conducting connection 10 accommodated in a hole of the layer 3 (as illustrated in Figure 12).

The invention proposed is economic and eco-sustainable, both because the material used is carbon-based (costly metals like silver are not used) and because the manufacturing processes implied do not use acids, metals and other pollutant products.

The invention presented here can be used for other applications such as conducting elements for de-icing applications, flexible heaters (shown by way of example in Fig. 7), electromagnetic screens, and flexible and chemically stable electrical interconnections.

It should be noted that the expression "aspect ratio" means the ratio between the longer dimension and the shorter dimension of a two-dimensional figure. The concept can be extended to include three-dimensional bodies by choosing two characteristic dimensions of the solid body.

The high aspect ratio and planar form of the graphene nanoplatelets that make up the sheet 7 make it possible to orientate them parallel to the sublayer, along the direction of the electric current, in this manner maximizing the conveyance of charge along the device 1 (the maximum conductivity of graphene that has currently been achieved is ~10⁵ S/m, although increases resulting from new methods of production are not ruled out).

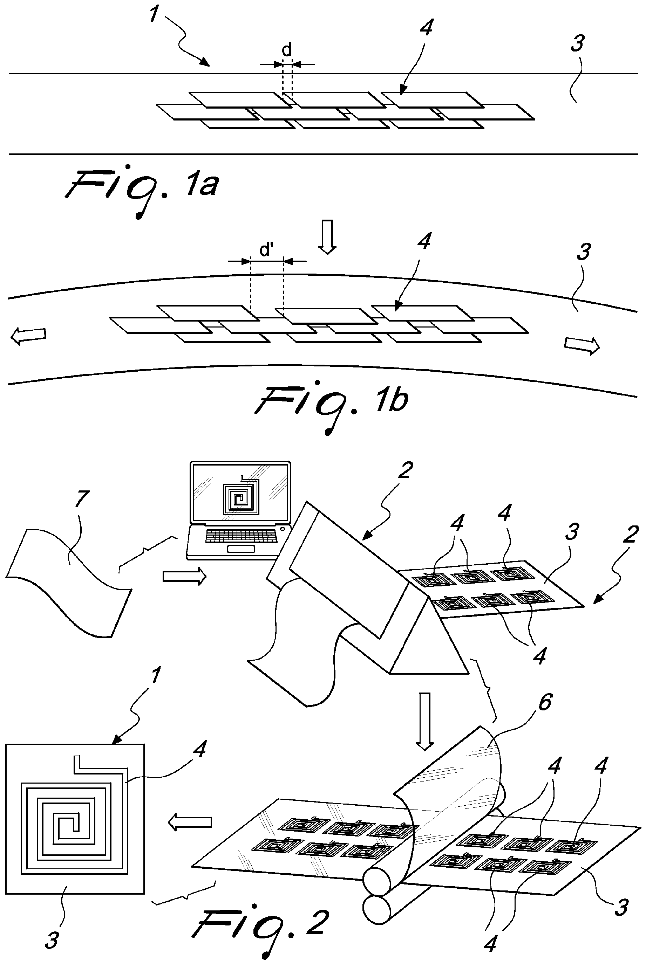

The two-dimensional form allows a better superimposition of the adjacent sheets (for an example see Figure 1), in this manner optimizing the conveyance of charge and reducing the contact resistance. In other standard conducting materials that are truly three-dimensional (e.g. nanoparticles), the contact between the particles may not be optimal and can change significantly on bending. On the other hand, in materials that are substantially one-dimensional (e.g. carbon nanotubes or metallic nanothreads), the flexibility will be good but the contact between adjacent threads will not be as good as that of flat sheets that are superimposed on each other.

Commercial sheets 7 of preassembled graphene derivatives with a thickness of a few microns can be easily folded without undergoing damage.

By virtue of their shape, graphene sheets will be more flexible than carbon nanotubes or metallic nanothreads. Furthermore, the sheets are capable of sliding over each other if they are flexed (again, see Figure 1 for a schematic diagram of the physical phenomenon described herein), thus maintaining a good adhesion by virtue of the strong Van der Waals interactions between the "p" orbitals of graphene. These interactions, differently from the bonds that form by cross-linking in normal glues or polymeric binders, are supramolecular in nature and are therefore completely reversible, thus enabling the conductor to be flexed thousands of times without deteriorating and without changing the electrical performance. The broad "sp²" net of graphene makes the material highly stable and resistant to oxidation from humidity and temperature variations.

In fact the substantially two-dimensional form of the material, in addition to ensuring a good electrical contact, also acts as a barrier to the diffusion of gas, by acting as a protective layer and preventing any influx of doping substances into the device 1 which could create unwanted doping, the creation of electronic traps, and hence changes in the performance of the device 1 proper (particularly disabling when the device 1 is an antenna).

The outer layers of the sheet 7 or of the layer 3 can also be partially chemically or physically functionalized with functional assemblies before coupling to the layer 3, in order to facilitate adhesion thereto.

These processes of functionalization can create "sp3" chemical defects only on the first layer of graphene that makes up the antenna (the device 1) and therefore they do not lead to degradation of the conductivity of the entire volume of the antenna (the device 1). Being composed of carbon, the sheet 7 will also be resistant to water and to humidity and it will not be subject to oxidation.

By contrast, the sheet 7 can act as a barrier to humidity with beneficial effects for the underlying layers.

The last advantage is related to the final disposal of the RFID antenna (the device 1). Since it is composed of carbon (as are the underlying polymeric materials), there are no restrictions on the disposal of the sheet 7 of preassembled graphene derivatives, differently from heavy metals. It has no dimensions on the nanometric scale, thus creating fewer problems of toxicity with respect to other nanomaterials like carbon nanotubes or metallic nanothreads.

Examples of implementation of the invention.

A sheet 7 of preassembled graphene derivatives, 50 micrometers thick, was used to provide samples adapted to evaluate the electrical, adhesion, flexibility and chemical stability properties of the material. The sheet 7 was cut into strips with a cutting plotter (dimensions: width 1 mm, length 2 cm). The sheet had first been laid on a sheet of polydimethylsiloxane (PDMS) in order to keep it still during the cutting operation and then it was removed therefrom. In addition to PDMS it is also possible to use a thermal release tape, or a polyvinyl chloride (PVC) adhesive film. The fixing layer may also not be removed.

Any other shape could have been provided with this instrument in order to provide the optimal design of the RFID antenna or of another type of device 1. The cutting plotter used was a Silhouette-Cameo plotter (the possibility is not ruled out of using other cutting plotters with different characteristics and of different types).

After cutting, the conducting paths 4 thus obtained were attached to a layer 3 of PET, 250 micrometers thick, covered in laminating pouch film (layer 9) by way of hot rolling (Leitz iLAM touch).

With an apparatus for measuring the surface resistance at four points, the resistance was measured on several devices 1 and an average surface resistance value of 0.055 Ω/□ was obtained for conducting paths having a thickness of 50 micrometers. The measurement was obtained by applying a current with an adjustable stabilized power supply (for example an "Agilent E3612A" device) and measuring the potential difference with an electrometer (such as for example a "Keithley 6514" device). No change in surface resistance was observed even after several foldings of the sample.

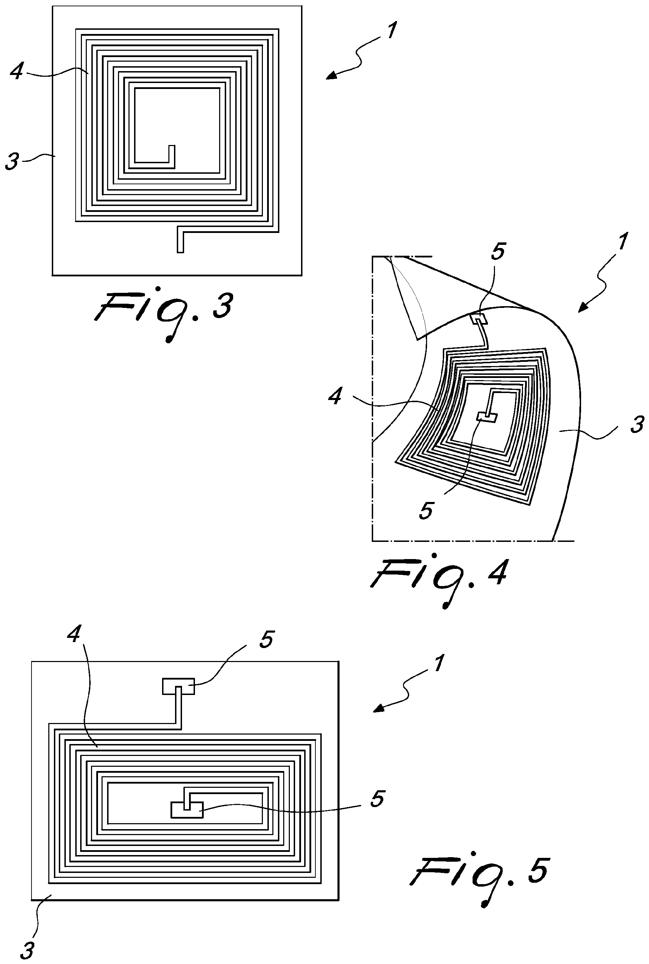

Some prototype flexible RFID-NFC antennae were prepared by following the teachings of the present invention. A sheet 7 of preassembled graphene derivatives, 50 micrometers thick, was cut with the cutting plotter into a specific shape. The sheet 7 had first been laid on a sheet of PDMS in order to keep it still during the cutting operation and then removed therefrom. After this, the conducting path was hot-rolled on a sheet of PET laminating pouch film, 250 micrometers thick. Chosen as design examples for the antenna were a square spiral shape structure (with a side dimension of 6 cm, 6 loops, track thickness 2 mm and gap thickness 1 mm) and a rectangular spiral shape structure (dimensions: length 7.5 cm, width 4.5 cm, with 6 loops, track thickness 2 mm and gap thickness 1 mm) as shown respectively in Figures 3 and 5.

For some prototypes, it was chosen to use (non-restrictively) connecting elements 5 of copper, obtained with sheets of copper, at the ends of the antenna (specific embodiment analyzed in this example for the device 1) in order to allow a better electrical contact between the antenna and the integrated circuit or another device (visible in Figures 4 and 5). The surface resistance of the antennae, measured with a four-point apparatus, is 0.055 Ω/□ ("ohms per square") and the overall resistance of the antenna is 24-26 Ohms (with measurement at four points).

Furthermore, non-exclusive examples were made of prototypes of conducting paths between 2 sheets of Kapton^{®} which were usable as heaters (Figure 7) and electromagnetic screens which were obtained by coupling sheets of preassembled graphene derivatives to films of PET.

The potential of graphene and of its derivatives is vast, and many scientific articles have shown that at the nanoscale this material is stronger than steel, conducts heat better than copper, is proof against all gases, is flexible and has better electrical properties than those of silicon, which is commonly used in computers.

Several conducting inks are currently used for printed electronics; in particular these comprise: noble metals, conducting polymers and carbon-based nanomaterials.

Silver is the material used most in this field, and many inks in fact are constituted of nanoparticles or precursors of silver. These inks have the highest conductivity in their category, but the precursors are very expensive.

Copper inks are also used, but typically they require treatments at high temperatures in order to produce very conductive tracks, thus limiting the choice of sublayers. Moreover, these inks are subject to rapid oxidation.

Conductive polymers, like poly(3.4-ethylenedioxythiophene)-poly(styrenesulfonate) (abbreviated to PEDOT:PSS), have also been used for applications in printed electronics.

Unfortunately the electrical conductivity of these materials is too low for applications like RFID antennae, and they also exhibit problems related to thermal and chemical stability.

Carbon-based inks offer a relatively low-cost alternative with an excellent chemical stability. For RFID antennae however, surface resistances of lower than 1-5 Ω/□ ("ohms per square") are required in order to have acceptable performance levels. Until now it has not been possible to produce efficient flexible antennae made with graphene derivatives, because with the approaches currently used the films obtained have low electrical conductivity.

A critical factor of these approaches is that the contact resistance between adjacent sheets of graphene can be very high if the sheets are not in good contact with each other, thus reducing the total conductivity in the film (even though a single graphene unit conducts current very well).

The RFID antenna, which constitutes the device 1, is provided starting from a sheet 7 of preassembled graphene derivatives. In the example shown, the sheet made with graphene nanoplatelets has a surface resistance of 0.05 Ω/□ ("ohms per square") on a thickness of 50 micrometers. Furthermore, we can expect to obtain better electrical resistance values by doping the material.

The different starting material, the different manufacturing process, and the different technique of depositing on the sublayer make it possible to obtain an electrical conductivity that is therefore adapted for this type of applications.

The invention proposed therefore makes it possible to produce flexible RFID antennae or interconnections made with sheets 7 of preassembled graphene derivatives, of the desired thickness, which are easily cut to shape with a cutting plotter or another cutting method, and easily coupled to any type of layer 3. The conducting paths 4 thus obtained are much more conductive than the graphene-based inks known at present.

By adopting the process 2 according to the invention, it is possible to also make other types of flexible devices 1, supported on polymeric and non-polymeric sublayers, such as for example heaters (shown by way of example in Figure 7), deicing elements, heat dissipators, EMI shielding (i.e. shielding for electromagnetic radiations) etc.

Graphene made by chemical vapor deposition (CVD) or exfoliated graphene is currently being intensely explored for making transparent conducting materials, with many publications and patents already available. In any case the electrical performance of these materials is at the moment very far from the values required in order to produce efficient RFID antennae. Since transparency properties are not necessary for RFID antennae, unlike applications for transparent electrodes where exfoliation is required down to a single layer, a top-down approach can be used that uses exfoliated graphite but without reaching the single layer, with clear advantages with respect to methods based on the exfoliation of graphene by sonication. The material used in this invention can be identified as halfway between bulk graphite and a sheet with just a few layers of graphene; in this manner the high conductivity and mechanical strength of the first are maintained, but at the same time it has the high flexibility of the second.

The processes used for this invention are scalable and use technologies that are already present in industry.

The same processes are also eco-sustainable, unlike the etching process commonly used in order to provide metallic RFID antennae.

Advantageously the present invention solves the above mentioned problems, by providing a device 1 of the type of an antenna, a heater, an electromagnetic screen, an electrical interconnection and the like which has high electrical conductivity, as amply shown also by virtue of the cited examples.

Positively the device 1 according to the invention also has a low surface resistance, good mechanical properties, and therefore it is very conductive even after bending, and it has good chemical stability.

Conveniently the process 2 for providing devices 1 of the type of an antenna, a heater, an electromagnetic screen, an electrical interconnection and the like makes it possible to obtain devices 1 with high electrical efficiency with methods that are simple and ecological.

Conveniently the process 2 according to the invention makes it possible to obtain devices 1 with good mechanical properties.

Conveniently the process 2 has low implementation costs.

Profitably the present invention also identifies a substantially laminar blank 100 for providing devices 1 of the type of an antenna, a heater, an electromagnetic screen, an electrical interconnection and the like which can be used simply, using machines that are already present in the industry for standard manufacturing processes.

Advantageously the blank 100 according to the invention ensures a uniformity of the devices 1 made with it, independently of the method of manufacture adopted.

Effectively the present invention makes it possible to provide a device 1 of the type of an antenna, a heater, an electromagnetic screen, an electrical interconnection and the like, by carrying out a process 2 for providing devices 1 of the type of an antenna, a heater, an electromagnetic screen, an electrical interconnection and the like which are low cost, easily and practically implemented and safe in use.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A process for providing devices (1) such as an antenna, a heater, an electromagnetic screen, an electrical interconnection and the like, which consists of:
- selecting at least one sheet (7) essentially constituted by a free-standing preassembled sheet of graphene derivatives;
- selecting at least one supporting layer (3) of material chosen from among polymeric, composite, ceramic, paper, natural substances and combinations and/or derivatives thereof;
- coupling at least one portion of said at least one sheet (7) and at least one portion of said at least one supporting layer (3), and shaping from said at least one sheet (7) at least one flexible ribbon-like conducting path (4) after the coupling of said at least one sheet (7) to said at least one supporting layer (3), thus obtaining a conducting path (4) that is integral with a respective supporting layer (3) that is identically shaped;
or
- shaping from said at least one sheet (7) at least one flexible ribbon-like conducting path (4) prior to the coupling of said at least one sheet (7) to said at least one supporting layer (3), and then coupling said conducting path (4) on said
supporting layer (3).

2. The process according to claim 1, **characterized in that** at the ends of at least one said ribbon-like conducting path (4) there are respective connecting elements (5) which are constituted by materials chosen preferably from among metals and polymers with good electrical conductivity.

3. The process according to one or more of claims 1 and 2,
**characterized in that** said step of coupling said at least one sheet (7) and at least one portion of said at least one supporting layer (3) is obtained by way of a method chosen from among hot rolling, adhesive bonding, cross-linking, interposition of coupling sheets, and the like.

4. The process according to one or more of claims 1, 2 and 3, **characterized in that** the step of shaping of at least one flexible ribbon-like conducting path (4) from said at least one sheet (7) is performed by way of a die cutter, a blade controlled by respective actuators, a cutting plotter, a laser system, a system using electrochemical processes, and the like.

5. The process according to claim 1, **characterized in that** it comprises a step of deposition of at least one covering and protection layer (6) above said flexible ribbon-like conducting path (4) and in possible at least partial contact with said supporting layer (3), said at least one protective layer (6) being made of a material chosen from among polymeric, composite, ceramic, paper, natural substances and combinations and/or derivatives thereof.

## Patentansprüche

1. Ein Verfahren zur Bereitstellung von Vorrichtungen (1) wie zum Beispiel einer Antenne, eines Heizgeräts, einer elektromagnetischen Abschirmung, einer elektrischen Verbindung und dergleichen, das in Folgendem besteht:
- dem Auswählen mindestens einer Folie (7), die im Wesentlichen aus einer selbst tragenden vormontierten Folie von Graphenderivaten besteht;
- dem Auswählen mindestens einer Trägerschicht (3) aus Material, das gewählt ist aus Polymeren, Verbundstoffen, Keramik, Papier, natürlichen Substanzen sowie Kombinationen und/oder Derivaten davon;
- dem Verbinden mindestens eines Teils der Folie (7) und mindestens eines Teils der mindestens einen Trägerschicht (3) und dem Formen mindestens einer biegsamen bandähnlichen Leiterbahn (4) aus der mindestens einen Folie (7) nach dem Verbinden der mindestens einen Folie (7) mit der mindestens einen Trägerschicht (3), wodurch eine Leiterbahn (4) gewonnen wird, die integral mit einer entsprechenden Trägerschicht (3) ist, welche identisch geformt ist;
oder
- dem Formen mindestens einer biegsamen bandähnlichen Leiterbahn (4) aus der mindestens einen Folie (7) vor dem Verbinden der mindestens einen Folie (7) mit der mindestens einen Trägerschicht (3) und dem anschließenden Koppeln der Leiterbahn (4) auf der Trägerschicht (3).

2. Das Verfahren gemäß Anspruch 1, **dadurch gekennzeichnet, dass** sich an den Enden der mindestens einen bandähnlichen Leiterbahn (4) entsprechende Verbindungselemente (5) befinden, die aus Materialien bestehen, welche vorzugsweise gewählt sind aus Metallen und Polymeren mit guter elektrischer Leitfähigkeit.

3. Das Verfahren gemäß einem oder mehreren der Ansprüche 1 und 2, **dadurch gekennzeichnet, dass** der Schritt des Verbindens der mindestens einen Folie (7) und mindestens eines Teils der mindestens einen Trägerschicht (3) mit Hilfe eines Verfahrens durchgeführt wird, das gewählt ist aus Warmwalzen, Kleben, Quervernetzen, Zwischenanbringen von Verbindungsfolien und dergleichen.

4. Das Verfahren gemäß einem oder mehreren der Ansprüche 1, 2 und 3, **dadurch gekennzeichnet, dass** der Schritt des Formens mindestens einer biegsamen bandähnlichen Leiterbahn (4) aus der mindestens einen Folie (7) mit Hilfe einer Stanze, einer durch entsprechende Antriebselemente gesteuerten Klinge, eines Schneideplotters, eines Lasersystems, eines Systems, das elektrochemische Verfahren nutzt, und dergleichen durchgeführt wird.

5. Das Verfahren gemäß Anspruch 1, **dadurch gekennzeichnet, dass** es einen Schritt des Auftragens mindestens einer Deck- und Schutzschicht (6) über die biegsame bandähnliche Leiterbahn (4) und in möglichem zumindest partiellem Kontakt mit der Trägerschicht (3) umfasst, wobei die mindestens eine Schutzschicht (6) aus einem Material besteht, das gewählt aus Polymeren, Verbundstoffen, Keramik, Papier, natürlichen Substanzen und Kombinationen und/oder Derivaten davon.

## Revendications

1. Procédé pour fournir des dispositifs (1) tels qu'une antenne, un élément chauffant, un écran électromagnétique, une interconnexion électrique et dispositifs similaires, comprenant les étapes suivantes :
- sélectionner au moins une feuille (7) constituée essentiellement d'une feuille de dérivés du graphène préassemblée et libre ;
- sélectionner au moins une couche de support (3) faite d'un matériau choisi parmi un polymère, un composite, une céramique, un papier, des substances naturelles et les combinaisons et/ou dérivés de ceux-ci ;
- accoupler au moins une partie de ladite au moins une feuille (7) et au moins une partie de ladite au moins une couche de support (3), et former à partir de ladite au moins une feuille (7) au moins un chemin conducteur en forme de ruban souple (4) après l'accouplement de ladite au moins une feuille (7) avec ladite au moins une couche de support (3), pour obtenir ainsi un chemin conducteur (4) qui est intégré à une couche de support respective (3) qui est de forme identique ;
ou
- former à partir de ladite au moins une feuille (7) au moins un chemin conducteur en forme de ruban souple (4) avant l'accouplement de ladite au moins une feuille (7) avec ladite au moins une couche de support (3), puis accoupler ledit chemin conducteur (4) sur ladite couche de support (3).

2. Procédé selon la revendication 1, **caractérisé en ce que** aux extrémités d'au moins l'un desdits chemins conducteurs en forme de ruban (4) se trouvent des éléments de connexion respectifs (5) qui sont constitués de matériaux choisis de préférence parmi les métaux et les polymères ayant une bonne conductivité électrique.

3. Procédé selon l'une ou plusieurs des revendications 1 et 2, **caractérisé en ce que** ladite étape d'accouplement de ladite au moins une feuille (7) et d'au moins une partie de ladite au moins une couche de support (3) est obtenue à l'aide d'un procédé choisi parmi le laminage à chaud, l'assemblage par collage, la réticulation, l'interposition de feuilles d'accouplement, et procédés similaires.

4. Procédé selon l'une ou plusieurs des revendications 1, 2 et 3, **caractérisé en ce que** l'étape de formation d'au moins un chemin conducteur en forme de ruban souple (4) à partir de ladite au moins une feuille (7) est réalisée au moyen d'un emporte-pièce, d'une lame commandée par des actionneurs respectifs, d'un traceur de découpe, d'un système laser, d'un système utilisant des processus électrochimiques, et systèmes similaires.

5. Procédé selon la revendication 1, **caractérisé en ce qu'**il comprend une étape de dépôt d'au moins une couche de couverture et de protection (6) sur ledit chemin conducteur en forme de ruban souple (4) et éventuellement en contact au moins partiel avec ladite couche de support (3), ladite au moins une couche de protection (6) étant faite d'un matériau choisi parmi un polymère, un composite, une céramique, un papier, des substances naturelles et les combinaisons et/ou dérivés de ceux-ci.
